# EUROPÄISCHE PATENTSCHRIFT

(11) **EP 3 928 600 B1**
(45) Veröffentlichungstag und Bekanntmachung des Hinweises auf die Patenterteilung: **07.06.2023**
(21) Anmeldenummer: 20710809.3
(22) Anmeldetag: 28.02.2020
(51) Int. Cl.: H05K 5/02, H05K 5/04, H05K 7/14

(54) **GEHÄUSEANORDNUNG**
HOUSING ASSEMBLY
ENSEMBLE BOITIER

(30) Priorität: 28.03.2019 DE 102019204306
(43) Veröffentlichungstag der Anmeldung: 29.12.2021
(73) Patentinhaber: Siemens Energy Global GmbH & Co. KG, 81739 München (DE)
(72) Erfinder: ARMSCHAT, Christoph, 91058 Erlangen (DE); SCHÄFER, Jochen, 91301 Kersbach (DE)
(86) Internationale Anmeldenummer: PCT/EP2020/055236
(87) Internationale Veröffentlichungsnummer: WO 2020/193064

(56) Entgegenhaltungen:
- EP-A1- 2 966 947
- WO-A1-2016/198088
- DE-A1- 10 245 103

## Beschreibung

Die Erfindung betrifft eine Gehäuseanordnung für eine elektronische Schaltung. Weiterhin betrifft die Erfindung ein Verfahren zum Klimatisieren einer in einer Gehäuseanordnung angeordneten elektronischen Schaltung.

Anlagen der Energieübertragung beinhalten oftmals Anlagenteile/Komponenten, die nicht durch Gebäude oder Ähnliches vor Umwelteinflüssen geschützt sind. Solche Komponenten können beispielsweise im Wechselspannungs-Freiluftschaltfeld (AC-Yard) oder im Gleichspannungs-Freiluftschaltfeld (DC-Yard)] einer Energieübertragungsanlage angeordnet sein; Beispiele dafür sind Geräte wie Stromwandler, Spannungswandler oder andere Hochspannungsschaltgeräte. (Die Erfindung ist aber beispielsweise auch für Geräte der Mittelspannung anwendbar, insbesondere für Mittelspannungsgeräte in Freiluftschaltfeldern.) Diese Komponenten/Geräte sind in der Regel mit einer großen Anzahl an elektrischen Kabeln mit einem Kontrollraum verbunden, in dem elektronische Schaltungen installiert sind. Diese elektronischen Schaltungen dienen beispielsweise zur Steuerung der Geräte oder zur Auswertung von Messwerten, die von den Geräten über die elektrischen Kabel zu dem Kontrollraum übertragen werden. Die elektronischen Schaltungen sind oftmals nicht freifeldtauglich, d.h. nicht für zum Teil extreme klimatische Bedingungen geeignet, wie sie im Freien auftreten können. Beispielsweise können die Temperaturen zwischen minus 40°C und plus 60°C schwanken und es kann (insbesondere in tropischen Regionen) dauerhaft hoher Niederschlag und eine sehr hohe relative Luftfeuchtigkeit vorhanden sein. Der Aufwand für die Verkabelung zwischen den Geräten und dem Kontrollraum ist jedoch oftmals hoch. Speziell bei im Freien installierten Messeinrichtungen kann zusätzlich das Problem auftreten, dass die elektrischen Kabel einen negativen Einfluss auf die Messgenauigkeit und/oder die Messperformance haben. Dies ist z.B. bei einem leistungslosen elektrischen Spannungsteiler (typ "ohmsch-kapazitiv") der Fall, der mittels langer Kabel mit dem Kontrollraum verbunden ist.

Aus der internationalen Patentanmeldung WO 2016/198088 A1 ist eine Vorrichtung zum Entfeuchten eines Schaltschranks bekannt. Die Vorrichtung umfasst mindestens ein Peltierelement und eine Einrichtung zum Abführen von kondensierter Feuchtigkeit aus dem Inneren in die Umgebung des Schaltschranks.

Die Offenlegungsschrift DE 102 45 103 A1 offenbart einen Schaltschrank für eine Windenergieanlage, der mindestens ein Schaltungselement beinhaltet. Eine Trocknungsanordnung vermeidet eine Wasserabscheidung auf dem Schaltungselement. Die Trocknungsanordnung weist eine Einrichtung zum Erzeugen einer Luftströmung im Bereich des Schaltungselements auf.

Der Erfindung liegt die Aufgabe zugrunde, eine Anordnung und ein Verfahren anzugeben, bei denen der Aufwand für die Installation von elektronischen Schaltungen außerhalb von Gebäuden verringert ist.

Diese Aufgabe wird erfindungsgemäß gelöst durch eine Gehäuseanordnung und durch ein Verfahren nach den unabhängigen Patentansprüchen. Vorteilhafte Ausführungsformen der Gehäuseanordnung und des Verfahrens sind in den abhängigen Patentansprüchen angegeben.

Offenbart wird eine Gehäuseanordnung für eine elektronische Schaltung mit einem Innengehäuse (inneres Gehäuse) und einem das Innengehäuse umgebenden Außengehäuse (äußeres Gehäuse), wobei das Innengehäuse thermisch isolierende Gehäusewände und eine elektrische Entfeuchtungseinrichtung (für das vom Innengehäuse umschlossene Volumen, insbesondere für die vom Innengehäuse umschlossene Luft) aufweist. Das Innengehäuse ist also in einem Innenraum des Außengehäuses angeordnet. Dabei ist besonders vorteilhaft, dass die Gehäuseanordnung ein (thermisch gut isolierendes) Innengehäuse und ein (mechanisch robustes) Außengehäuse aufweist. Die elektronische Schaltung befindet sich in dem Innengehäuse und kann dort klimatisiert werden. Das Außengehäuse umschließt das Innengehäuse bietet einen verbesserten mechanischen Schutz für die empfindliche elektronische Schaltung. Mittels der elektrischen Entfeuchtungseinrichtung kann die Feuchtigkeit in dem Innengehäuse verringert werden.

Die Gehäuseanordnung kann so ausgestaltet sein, dass
- das Innengehäuse ein Volumen umschließt, das maximal 50 % des Volumens beträgt, welches das Außengehäuse umschließt. Dadurch lässt sich das Innengehäuse mit vergleichsweise wenig Aufwand klimatisieren, um die elektronische Schaltung vor Klimaschwankungen zu schützen. Dahingegen braucht der Zwischenraum zwischen dem Innengehäuse und dem Außengehäuse weniger exakt klimatisiert zu werden, im Extremfall braucht dieser Zwischenraum überhaupt nicht klimatisiert zu werden. Insbesondere der Energieaufwand für die Klimatisierung wird dadurch verringert.

Die Gehäuseanordnung kann auch so ausgestaltet sein, dass
- die Entfeuchtungseinrichtung ein Peltierelement und eine Kondensatabführung aufweist.

Mittels des Peltierelements kann die Entfeuchtung des Innenraums des Innengehäuses einfach und ohne die Notwendigkeit rotierender Teile durchgeführt werden. Dadurch ergibt sich eine hohe Zuverlässigkeit und Lebensdauer der Entfeuchtungseinrichtung und der Gehäuseanordnung. An der kalten Seite des Peltierelements kondensiert die Feuchtigkeit aus dem Innenraum des Innengehäuses und wird mittels der Kondensatabführung aus dem Innengehäuse abgeführt.

Dabei ist insbesondere die Kaltseite des Peltierelements zum Innenraum des Innengehäuses hin orientiert, wohingegen die Warmseite des Peltierelements vom Innenraum des Innengehäuses weg (d.h. zum Außengehäuse hin) orientiert ist.

Die Gehäuseanordnung kann auch so ausgestaltet sein, dass
- das Peltierelement in der Lage ist, eine Temperaturdifferenz von 40 Kelvin (optional auch eine noch höhere Temperaturdifferenz) zu erzeugen.

Diese Temperaturdifferenz kann insbesondere durch eine thermische Reihenschaltung von mehreren Einzel-Peltierelementen erreicht werden. Damit kann auch bei einer extremen relativen Luftfeuchtigkeit von zum Beispiel 100 % (in tropischen Gegenden) das Innengehäuse zuverlässig entfeuchtet werden.

Die Gehäuseanordnung kann auch so ausgestaltet sein, dass
- die Kondensatabführung Kapillaren aufweist.

Die Kapillaren sind besonders vorteilhaft, weil sie (im Gegensatz zu einem einfachen Kondensatabführschlauch) keinen nennenswerten offenen Querschnitt aufweisen. Derartige offene Querschnitte ermöglichen einen unerwünschten Luftaustausch zwischen dem Innenraum des Innengehäuses und der Umgebung der Gehäuseanordnung, durch den wieder Feuchtigkeit in das Innengehäuse eindringen kann. Außerdem besteht bei offenen Querschnitten die Gefahr, dass diese offenen Querschnitte mit der Zeit durch Schmutz oder biologischen Bewuchs zugesetzt werden. Diesen Nachteil weisen Kapillaren nicht auf. Die Kapillaren ziehen das Kondensat aus dem Innengehäuse heraus. Insbesondere können die Kapillaren zusätzlich zu einem kleinen offenen Abfluss-Querschnitt von beispielsweise 4 mm² installiert werden (oder anstelle eines offenen Abfluss-Querschnitts). Der offenen Abfluss-Querschnitt kann aber auch geringfügig größer sein, beispielsweise zwischen 4 mm² und 10 mm² betragen.

Die Gehäuseanordnung kann auch so ausgestaltet sein, dass
- die Kapillaren beheizbar sind.

Dadurch wird verhindert, dass die Kapillaren und damit die Kondensatabführung bei Temperaturen unter dem Gefrierpunkt vereisen.

Die Gehäuseanordnung kann auch so ausgestaltet sein, dass
- den Kapillaren eine elektrische Beheizungsvorrichtung zugeordnet ist, insbesondere ein elektrischer Heizdraht.

Mittels einer derartigen elektrischen Beheizungsvorrichtung kann einfach und gezielt eine Vereisung der Kapillaren vermieden werden.

Die Gehäuseanordnung kann auch so ausgestaltet sein, dass
- eine Stromversorgungseinrichtung für die Entfeuchtungseinrichtung in einem Zwischenraum zwischen dem Innengehäuse und dem Außengehäuse angeordnet ist.

Die Stromversorgungseinrichtung ist also nicht in dem Innengehäuse angeordnet, sondern außerhalb des Innengehäuses, aber innerhalb des Außengehäuses.

Stromversorgungseinrichtungen sind (verglichen mit der elektronischen Schaltung in dem Innengehäuse) vergleichsweise robust und können beispielsweise einen Transformator und einen Gleichrichter aufweisen. Handelsübliche geeignete Stromversorgungseinrichtungen brauchen oft nicht so exakt klimatisiert zu werden wie die zu schützende empfindliche elektronische Schaltung in dem Innengehäuse. Deshalb ist die Stromversorgung außerhalb des Innengehäuses angeordnet. Dadurch kann das Innengehäuse klein gehalten werden, der Aufwand für die exakte Klimatisierung des Innengehäuses kann reduziert werden.

Die Gehäuseanordnung kann auch so ausgestaltet sein, dass - in dem Zwischenraum zwischen dem Innengehäuse und dem Außengehäuse eine zusätzliche Entfeuchtungseinrichtung angeordnet ist, die insbesondere ein zusätzliches Peltierelement aufweist.

Mit dieser zusätzlichen Entfeuchtungseinrichtung kann optional auch das Außengehäuse entfeuchtet werden. Hierbei kann eine Entfeuchtungseinrichtung kleinerer Leistung als die Entfeuchtungseinrichtung des Innengehäuses ausreichend sein, weil das Außengehäuse nicht so schnell und genau entfeuchtet werden muss wie das Innengehäuse.

Die Gehäuseanordnung kann auch so ausgestaltet sein, dass
- in dem Innengehäuse ein elektrisches Heizelement (zum Erwärmen des Innenraumes des Innengehäuses) angeordnet ist. Mit diesem elektrischen Heizelement kann das Innengehäuse erwärmt werden. Insbesondere kann mit dem elektrischen Heizelement der kühlende Einfluss der Entfeuchtungseinrichtung kompensiert werden, um so eine gewünschte Temperatur in dem Innengehäuse einzustellen.

Die Gehäuseanordnung ist so ausgestaltet, dass
- in dem Innengehäuse und/oder dem Außengehäuse ein Feuchtigkeitspuffer angeordnet ist.

Durch den Feuchtigkeitspuffer kann vorteilhafterweise vermieden werden, dass sich bei Betrieb der Entfeuchtungseinrichtung die Luftfeuchtigkeit in dem Innengehäuse und/oder in dem Außengehäuse zu schnell erhöht oder verringert und der Innenraum des Innengehäuses und/oder des Außengehäuses zu schnell feucht wird oder trocknet (was ungünstig für die elektronische Schaltung wäre).

Die Gehäuseanordnung ist so ausgestaltet, dass
- der Feuchtigkeitspuffer ein hygroskopisches Material aufweist.

Das hygroskopische Material nimmt bei hoher relativer Luftfeuchtigkeit in dem Innengehäuse Feuchtigkeit auf und gibt diese bei niedrigerer relativer Luftfeuchtigkeit (langsam) wieder in den Innenraum des Innengehäuses ab.

Die Gehäuseanordnung ist so ausgestaltet, dass
- der Feuchtigkeitspuffer elektrisch beheizbar ist, um von dem hygroskopischen Material gebundenes Wasser in den gasförmigen Aggregatzustand zu überführen.

Damit kann bei Bedarf der Feuchtigkeitspuffer regeneriert werden, falls dieser durch langanhaltende hohe Feuchtigkeit viel Wasser aufgenommen hat und dieses nicht auf natürlichem Wege wieder abgeben kann. Mittels einer dem Feuchtigkeitspuffer zugeordneten elektrischen Heizung ist der Feuchtigkeitspuffer gezielt/gesteuert beheizbar.

Die Gehäuseanordnung kann auch so ausgestaltet sein, dass
- in dem Innengehäuse ein Wärmepuffer angeordnet ist. Dabei ist der Wärmepuffer insbesondere zwischen dem elektrischen Heizelement und der elektronischen Schaltung angeordnet.

Da das Innengehäuse vergleichsweise klein ist, und die darin angeordnete elektronische Schaltung in der Regel nur wenig Material und eine geringe Wärmekapazität aufweist, besteht die Gefahr von großen Temperaturschwankungen in dem Innengehäuse. Diese Temperaturschwankungen werden durch den Wärmepuffer gedämpft. Der Wärmepuffer nimmt bei hoher Temperatur Wärme auf und gibt diese bei niedriger Temperatur wieder (langsam) in den Innenraum des Innengehäuses ab. Durch die Anordnung des Wärmepuffers zwischen dem elektrischen Heizelement und der elektronischen Schaltung werden insbesondere vorteilhafterweise zu hohe Temperaturschwankungen nach Einschalten des elektrischen Heizelementes vermieden.

Die Gehäuseanordnung kann dabei so ausgestaltet sein, dass
- der Wärmepuffer ein (massives) wärmepufferndes Metallteil aufweist.

Ein derartiges wärmepufferndes Metallteil weist eine größere Wärmekapazität auf als die elektronische Schaltung und ist daher in der Lage, vergleichsweise viel Wärme aufzunehmen und abzugeben und damit die Temperaturschwankungen zu begrenzen.

Die Gehäuseanordnung kann auch so ausgestaltet sein, dass
- eine Wand des Innengehäuses als eine Haltewand für die elektronische Schaltung ausgestaltet ist, insbesondere als eine (thermisch gut isolierende) Montageplatte.

Diese Haltewand kann beispielsweise aus einem Schaumstoff hoher Dichte bestehen, insbesondere aus Styropor hoher Dichte. An der Haltewand kann die elektronische Schaltung montiert werden. Die übrigen Wände des Innengehäuses können insbesondere als ein Aufsatzgehäuse ausgestaltet sein bzw. ein Aufsatzgehäuse bilden, welches auf die Haltewand aufgesetzt wird. Dadurch kann das Innengehäuse geöffnet und geschlossen werden. Das Aufsatzgehäuse kann dabei insbesondere die Haltewand umgreifen.

Nach Abnehmen des Aufsatzgehäuses ist die auf der Montageplatte installierte elektronische Schaltung von allen Seiten gut zugänglich.

Die Gehäuseanordnung kann so ausgestaltet sein, dass
- das Außengehäuse ein Metallgehäuse ist.

Das Metallgehäuse kann z.B. aus Stahl bestehen. Das Metallgehäuse bietet einen mechanischen Schutz und Regenschutz und es liefert die genormte Schutzklasse (z.B. IP55) für das äußere Gehäuse sowie auch für das darin angeordnete Innengehäuse und die weiteren darin angeordneten Komponenten (Stromversorgung und Ähnliches).

Die Gehäuseanordnung kann auch so ausgestaltet sein, dass
- die Gehäuseanordnung frei von rotierenden Teilen ist, insbesondere frei von elektrischen Kompressoren. Dadurch ist die Gehäuseanordnung weitgehend wartungsfrei, kann ein kleines Volumen aufweisen und die Klimatisierung kann energiesparend erfolgen.

Offenbart wird weiterhin ein Verfahren zum Klimatisieren einer in einer Gehäuseanordnung angeordneten elektronischen Schaltung, wobei die Gehäuseanordnung ein Innengehäuse und ein das Innengehäuse umgebendes Außengehäuse aufweist und das Innengehäuse thermisch isolierende Gehäusewände und eine elektrische Entfeuchtungseinrichtung (für das vom Innengehäuse umschlossene Volumen, insbesondere für die vom Innengehäuse umschlossene Luft) aufweist, wobei bei dem Verfahren
- bei Überschreiten eines Schwellenwertes der relativen Luftfeuchtigkeit in dem Innengehäuse die Entfeuchtungseinrichtung eingeschaltet wird und dadurch die relative Luftfeuchtigkeit in dem Innengehäuse reduziert wird.

Dieses Verfahren kann so ablaufen, dass
- die Entfeuchtungseinrichtung ein Peltierelement aufweist, wobei das Peltierelement abwechselnd als Kühlelement und als Heizelement für den Innenraum des Innengehäuses betrieben wird (alternierender Betrieb des Peltierelements als Kühlelement/Entfeuchtungselement und als Heizelement).

Dadurch wird eine dauerhafte Vereisung der Kaltseite des Peltierelements verhindert. Dies ist insbesondere bei tiefen oder negativen Lufttemperaturen um die Gehäuseanordnung herum vorteilhaft, also beispielsweise im Winter bei tiefen Außentemperaturen. Dabei kann die Gehäuseanordnung weiterhin einen Feuchtigkeitssensor und eine Regelung für das Peltierelement aufweisen.

Die beschriebene Anordnung und das beschriebene Verfahren weisen gleiche bzw. gleichartige Vorteile auf.

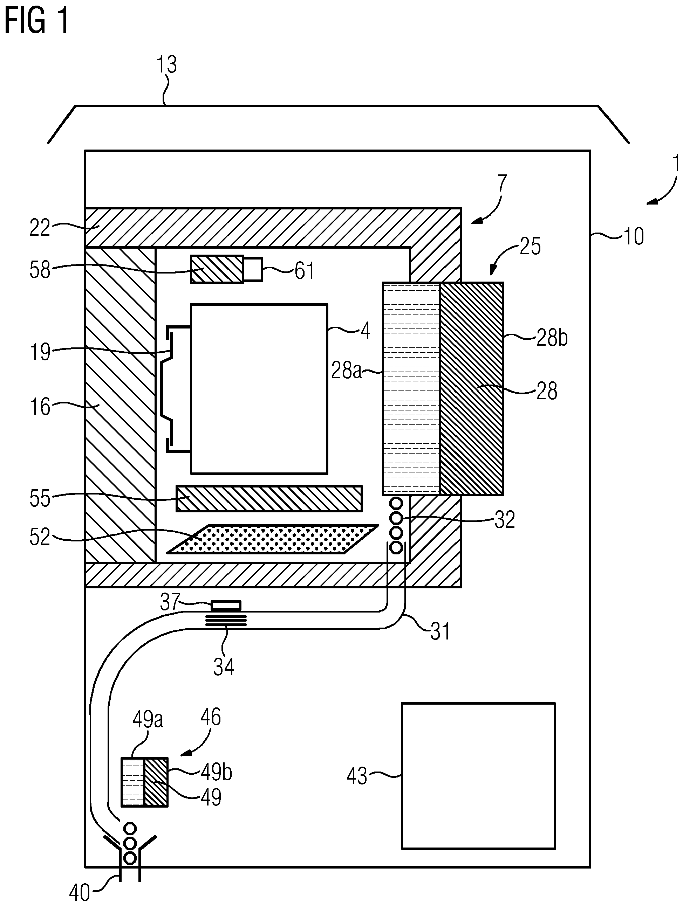

Im Folgenden wird die Erfindung anhand eines Ausführungsbeispiels näher erläutert. Dazu ist in
Figur 1 ein Ausführungsbeispiel einer Gehäuseanordnung dargestellt.

Figur 1 zeigt in einer teilweisen Schnittdarstellung eine Gehäuseanordnung 1 für eine elektronische Schaltung 4. Die Gehäuseanordnung 1 weist ein Innengehäuse 7 und ein Außengehäuse 10 auf. Das Innengehäuse 7 ist in dem Außengehäuse 10 angeordnet; das Außengehäuse 10 umschließt also allseitig das Innengehäuse 7. Dem Außengehäuse 10 ist ein Dach 13 zugeordnet, welches die Gehäuse beispielsweise vor Sonneneinstrahlung schützt. Das Außengehäuse 10 ist im Ausführungsbeispiel ein Metallgehäuse 10, insbesondere ein Stahlgehäuse oder ein Aluminium-(Druckguss-)Gehäuse. Das Innengehäuse 7 weist thermisch isolierende Gehäusewände auf. Die Gehäusewände können insbesondere einen Schaumstoff wie Styropor o.ä. aufweisen. Eine Gehäusewand ist dabei als eine Haltewand 16 ausgebildet. Die Haltewand 16 ist an einer Wand des Außengehäuses 10 befestigt. Die Haltewand 16 trägt die elektronische Schaltung 4. Dazu ist an der Haltewand 16 beispielsweise eine Hutschiene 19 befestigt, an der die elektronische Schaltung 4 befestigt ist. Insbesondere ist die elektronische Schaltung 4 mittels einer Schnappverbindung mit der Hutschiene 19 verbunden. Die übrigen Wände des Innengehäuses 7 bilden ein Aufsatzgehäuse 22. Dieses Aufsatzgehäuse 22 kann auf die Haltewand 16 aufgesetzt/aufgesteckt bzw. von der Haltewand 16 entfernt werden. Dies ermöglicht einen bequemen Zugang zu den im Innenraum des Innengehäuses 7 angeordneten Teilen, insbesondere zu der elektronischen Schaltung 4.

Das Innengehäuse umschließt im Allgemeinen ein Volumen, welches maximal 50 % desjenigen Volumens beträgt, welches das Außengehäuse umschließt. Im Ausführungsbeispiel ist das Volumen des Innengehäuses im Vergleich zum Volumen des Außengehäuses noch kleiner: Das Volumen des Innengehäuses beträgt ca. 20 % des Volumens des Außengehäuses. Dadurch lässt sich das vom Innengehäuse umschlossene Volumen mit vergleichsweise geringem Energieaufwand klimatisieren.

Das Innengehäuse 7 weist eine elektrische Entfeuchtungseinrichtung 25 auf. Im Ausführungsbeispiel weist die elektrische Entfeuchtungseinrichtung 25 ein Peltierelement 28 und eine Kondensatabführung 31 auf. Das Peltierelement 28 ist insbesondere in der Lage, zwischen seiner Kaltseite 28a und seiner Warmseite 28b eine Temperaturdifferenz von 40 Kelvin und optional mehr zu erzeugen. Dazu können ggf. auch mehrere Einzel-Peltierelemente thermisch in Reihe geschaltet sein. In anderen Ausführungsbeispielen kann jedoch auch ein Peltierelement verwendet werden, welches eine andere Temperaturdifferenz erzeugt. An der Kaltseite 28a des Peltierelements 28 kondensiert Luftfeuchtigkeit aus dem Innenraum des Innengehäuses 7 und fließt als Kondensat 32 (insbesondere in Form von Kondensattropfen 32) in die Kondensatabführung 31. Die Kondensatabführung 31 weist Kapillaren 34 auf, welche im Ausführungsbeispiel lediglich an einer Stelle schematisch dargestellt sind. Diese Kapillaren 34 sind mit einer elektrischen Beheizungsvorrichtung 37 elektrisch beheizbar. Die Beheizungsvorrichtung 37 kann insbesondere als ein elektrischer Heizdraht 37 ausgestaltet sein, um die Kapillaren 34 zu beheizen. Die Kondensatabführung 31 transportiert das Kondensat 32 aus dem Innengehäuse 7 heraus in das Außengehäuse 10. Im Außengehäuse 10 gelangt das Kondensat 32 in einen Kondensatauslass 40, welcher das Kondensat in die Umgebung des Außengehäuses 10 ausgibt.

Im Ausführungsbeispiel sind die Kapillaren 34 und die Beheizungsvorrichtung 37 (insbesondere der Heizdraht 37) aus Gründen der Übersichtlichkeit nur an einer Stelle der Kondensatabführung 31 eingezeichnet. Es ist aber vorteilhaft, wenn sich die Kapillaren 34 über die gesamte Kondensatabführung 31 erstrecken. Dann kann mittels der Kapillaren 34 das Kondensat aus dem Innengehäuse 7 heraustransportiert werden. Ebenso ist es vorteilhaft, wenn die Beheizungsvorrichtung 37 die gesamte Kondensatabführung 31 beheizt, wenn also die Beheizungsvorrichtung 37 insbesondere über die gesamte Länge der Kondensatabführung 31 angeordnet ist. Es liegt dann ein kapillarer Kondensatabführungs-Pfad vor, insbesondere ein durchgängig beheizbarer (insbesondere kapillarer) Kondensatabführungs-Pfad (mit Gefälle) vom Innengehäuse 7 in das Außengehäuse 10 und insbesondere bis zur Umgebung des Außengehäuses vor. Optional kann auch der Kondensatauslass 40 mit der Beheizungsvorrichtung (oder einen eigenen Beheizungsvorrichtung) beheizbar sein.

Eine Stromversorgungseinrichtung 43 für die Entfeuchtungseinrichtung 25 ist im Außengehäuse 10 angeordnet. Genauer gesagt ist die Stromversorgungseinrichtung 43 in einem Zwischenraum zwischen dem Innengehäuse 7 und dem Außengehäuse 10 angeordnet. Die Stromversorgungseinrichtung 43 versorgt insbesondere das Peltierelement 28 und die elektrische Beheizungsvorrichtung 37 mit elektrischem Strom. Die Stromversorgungseinrichtung 43 kann aber auch andere Einrichtungen der Gehäuseanordnung mit elektrischem Strom versorgen. Die Stromversorgungseinrichtung 43 ist relativ robust, so dass diese nicht in dem thermisch isolierten Innengehäuse 7 angeordnet zu sein braucht. Dadurch kann das Innengehäuse 7 relativ kompakt gehalten werden.

In dem Zwischenraum zwischen dem Innengehäuse 7 und dem Außengehäuse 10 kann optional eine zusätzliche Entfeuchtungseinrichtung 46 angeordnet sein, welche ein zusätzliches Peltierelement 49 aufweist. Dieses zusätzliche Peltierelement 49 weist ebenfalls eine kalte Seite 49a (Kaltseite 49a) und eine warme Seite 49b (Warmseite 49b) auf. Damit kann optional auch der Innenraum des Außengehäuses 10 entfeuchtet werden. Das an der Kaltseite 49a des zusätzlichen Peltierelements 49 kondensierende Kondensat gelangt ebenfalls über den Kondensatauslass 40 aus dem Außengehäuse 10 heraus.

In dem Innengehäuse 7 ist weiterhin ein elektrisches Heizelement 52 angeordnet. Dieses elektrische Heizelement 52 dient der Beheizung des Innenraums des Innengehäuses 7. Weiterhin ist in dem Innengehäuse 7 ein Wärmepuffer 55 angeordnet. Dieser Wärmepuffer 55 ist vorzugsweise zwischen dem elektrischen Heizelement 52 und der elektronischen Schaltung 4 angeordnet. Der Wärmepuffer schützt die elektronische Schaltung 4 vor einer schlagartigen Temperaturerhöhung, die beispielsweise beim Einschalten des elektrischen Heizelementes 52 auftreten kann. Der Wärmepuffer 55 kann als ein Metallteil ausgestaltet sein, beispielsweise als eine Metallplatte. Ein derartiger Wärmepuffer 55 weist eine große Wärmekapazität auf, so dass er den Innenraum des Innengehäuses 7 vor plötzlichen Temperatursprüngen schützen kann.

In dem Innengehäuse 7 ist ein Feuchtigkeitspuffer 58 angeordnet. Dieser Feuchtigkeitspuffer 58 weist ein hygroskopisches Material auf, beispielsweise Tonerde. Dieser Feuchtigkeitspuffer 58 dämpft die Feuchtigkeitsänderung im Innenraum des Innengehäuses 7. Derartige Feuchtigkeitsänderungen können sonst schlagartig beispielsweise beim Einschalten der Entfeuchtungseinrichtung 25 auftreten; dies ist für die elektronische Schaltung 4 ungünstig. Der Feuchtigkeitspuffer 58 ist mittels einer Heizung 61 elektrisch beheizbar. Bei Beheizung des Feuchtigkeitspuffers 58 kann von dem hygroskopischen Material gebundenes Wasser verdampfen, d.h. in den gasförmigen Aggregatszustand überführt werden. Dies ermöglicht es, einen mit Wasser gesättigten Feuchtigkeitspuffer zu regenerieren und das Wasser aus diesem sozusagen auszuheizen.

Das elektrische Heizelement 52, zusätzliche Entfeuchtungseinrichtung 46 und/oder die Heizung 61 des Feuchtigkeitspuffers 58 kann ebenfalls von der Stromversorgungseinrichtung 43 mit elektrischem Strom versorgt werden.

Vorteilhafterweise ist die Gehäuseanordnung 1 frei von rotierenden Teilen, insbesondere frei von elektrischen Kompressoren (wie sie bei herkömmlichen Kühlaggregaten eingesetzt werden). Dadurch ist die Gehäuseanordnung weitgehend wartungsfrei, weist ein geringes Volumen auf und kann energiesparend betrieben werden.

Wenn die relative Luftfeuchtigkeit in dem Innengehäuse 7 einen Schwellenwert überschreitet, dann wird dies mittels einer Luftfeuchtigkeitsmessung (mit einem nicht dargestellten Sensor) erkannt und daraufhin die Entfeuchtungseinrichtung 25 eingeschaltet. Um insbesondere bei negativen Außentemperaturen eine Vereisung des Peltierelements 28 auf seiner Kaltseite 28a zu vermeiden, wird das Peltierelement 28 abwechselnd als Kühlelement und als Heizelement für den Innenraum des Innengehäuses 7 betrieben. Dies erfolgt durch Umkehrung der Stromrichtung des durch das Peltierelement 28 fließenden elektrischen Stroms. Dadurch kann das Peltierelement optional auch als Heizeinrichtung für den Innenraum des Innengehäuses 7 genutzt werden. Bei dem abwechselnden Betrieb als Kühlelement und als Heizelement steht allerdings nicht die Heizfunktion im Vordergrund, sondern das Verhindern einer dauerhaften Vereisung der Kaltseite 28a des Peltierelements 28.

Es wurde eine Gehäuseanordnung und ein Verfahren zum Klimatisieren einer in der Gehäuseanordnung angeordneten elektronischen Schaltung beschrieben. Dabei wird die Gehäuseanordnung gleichzeitig beheizt, gekühlt und/oder entfeuchtet, um klimatische- und EMV-Umgebungsbedingungen zu schaffen, die den Einsatz von empfindlichen elektronischen Schaltungen (insbesondere in verteilter Anwendung) im Freien erlaubt. Dabei wird die empfindliche elektronische Schaltung in einem inneren Gehäuse (Innengehäuse) installiert, um die benötigte elektrische Heizleistung, Kühlleistung und/oder Entfeuchtungsleistung zu verringern. Das äußere Gehäuse (Außengehäuse) dient insbesondere dem mechanischen Schutz und beinhaltet die Stromversorgung und/oder andere, vergleichbar robuste Komponenten.

Vorteile/Anwendungsbeispiele:
- eine Umsetzung von elektrischen Signalen (z.B. Messsignalen) kann direkt vor Ort in optische Signale erfolgen
- die vor Ort vorhandenen Signale können eben dort bereits (vor)verarbeitet werden
- die Verkabelung erfolgt z.B. nur noch mit vergleichsweise wenigen vergleichsweise günstigen, robusten, zuverlässigen und schnellen Lichtwellenleiterverbindungen, ohne dass Performanceeinbußen entstehen

Es wird insbesondere eine Lufttrocknung mit Feuchtigkeitsabfuhr durchgeführt. Es werden keine drehenden Teile eingesetzt, wodurch sich eine hohe Zuverlässigkeit ergibt.

Vorteilhafterweise wird eine "Box-in-Box"-Anordnung, insbesondere eine "Isolierbox-in-Metallbox"-Anordnung verwendet, d.h. das isolierende Innengehäuse ist in dem mechanisch stabilen Außengehäuse angeordnet. Die empfindliche (Anwendungs-)Elektronik befindet sich in dem Innengehäuse, dadurch wird das zu klimatisierende Volumen verringert. Es können auch mehrere Innengehäuse ("innere Isolierboxen") in dem Außengehäuse angeordnet sein (redundanter Aufbau). Als Außengehäuse (zum Beispiel Metallbox) kann ein bereits vorhandener Anschluss- oder Klemmenkasten verwendet werden oder es können Außengehäuse zusätzlich zu vorhandenen Anschluss- oder Klemmenkästen installiert werden.

Im Außengehäuse kann zur Feuchtigkeitskontrolle das zusätzliche Peltierelement (insbesondere mit hoher Temperaturdifferenz) installiert werden, welches durch die auf einer Seite besonders kalte Oberfläche die Luftfeuchtigkeit im gesamten Außengehäuse ausfallen lässt. Eine zugehörige Kondensatabführung/Kondensatablauf transportiert das Kondensat aus dem Außengehäuse hinaus. Dieses zusätzliche Peltierelement zur Feuchteabfuhr ändert die Temperatur im Außengehäuse nicht in relevanter Art und Weise.

Die Stromversorgungseinrichtung sowohl für die Peltierelemente, die elektronische Schaltung und/oder notwendige Sensoren ist im Außengehäuse angeordnet, da die Stromversorgungseinrichtung vergleichsweise robust und daher unempfindlich gegenüber Klimaschwankungen ist.

Die Wände des Innengehäuses bestehen aus thermisch gut isolierendem Material. Die Rückwand des Innengehäuses (Haltewand 16) ist als thermisch gut isolierende und mechanisch ausreichend feste Montageplatte für die elektronische Schaltung ("Anwendungselektronik") ausgeführt und trägt z.B. eine Hutschiene. Der Deckel (Aufsatzgehäuse 22) des Innengehäuses weist 4 Außenseiten auf sowie an der Frontseite die Peltierelement-basierte Entfeuchtungseinrichtung. Das Peltierelement stellt dabei einen Flächenkühler dar. Insbesondere können mehrere Peltierelemente zur Erhöhung der Betriebssicherheit und/oder zur Leistungssteigerung bei der Entfeuchtung verwendet werden. Mittels des bzw. der Peltierelemente kann optional auch die beim Betrieb der elektronischen Schaltung entstehende Wärme abgeführt werden, insbesondere bei hohen Außentemperaturen. Die dem Innengehäuse zugeordnete Kondensatabführung kann in der Kondensatabführung/Kondensatauslass des Außengehäuses münden.

Optional ist am Boden des Innengehäuses ein elektrisches (großflächiges) Heizelement angebracht. Dieses Heizelement kann insbesondere dann eingesetzt werden, wenn die Heizleistung des im "Heizbetrieb" gefahrenen Flächenkühlers (Peltierelement) nicht ausreicht.

Das Innengehäuse mit der Anwendungselektronik (d.h. mit der elektronischen Schaltung) ist weitgehend luftdicht ausgeführt, um den Feuchtigkeitseintrag aus dem Außengehäuse gering zu halten.

Die Steuerung der Entfeuchtungseinrichtung und/oder des elektrischen Heizelements erfolgt über eine Feuchteregelung bzw. Temperaturregelung. Dazu ist mindestens ein Temperatursensor und/oder ein Feuchtigkeitssensor im Inneren des Innengehäuses angeordnet. Optional wird die Regelung von der Anwendungselektronik selbst ausgeführt.

Bei zu hoher relativer Feuchte (relativer Luftfeuchtigkeit) im Innengehäuse wird mittels des Peltierelements im Innengehäuse der Innenraum der Gehäuseanordnung gekühlt und damit entfeuchtet. Zusätzlich kann das elektrische Heizelement im Innengehäuse eingeschaltet werden, um die relative Feuchtigkeit durch Erhöhung der Temperatur abzusenken. Optional kann auch das zusätzliche Peltierelement im Außengehäuse eingeschaltet werden, um die Gehäuseanordnung zu entfeuchten.

Die Abfuhr des Kondenswassers/Kondensats kann durch die Kondensatabführung mit sehr kleinem freien Querschnitt erfolgen, insbesondere mittels beheizbarer Kapillaren. Kapillaren sind insbesondere deshalb vorteilhaft, weil offene Querschnitte (in Schläuchen o.ä.) einen (hier unerwünschten) Luftaustausch mit der Umgebung ermöglichen. Außerdem können offene Querschnitte mit der Zeit durch Schmutz und biologischen Bewuchs zugesetzt werden. Daher ist in der Kondensatabführung nur ein kleiner offener Abflussquerschnitt vorgesehen. Vorteilhafterweise leiten die Kapillaren der Kondensatabführung das Kondensat (nach unten) zum Kondensatauslass 40 (zum Beispiel Kondensatablauf) des Außengehäuses. Die Kondensatabführung 31, der Kondensatauslass 40 und/oder die Kapillaren können mit einer Beschichtung aus einem fungiziden Material oder aus einem bewuchshemmenden Material (Hemmung eines biologischen Bewuchses) versehen sein.

Beispielsweise wird die Entfeuchtungseinrichtung 25 im Innengehäuse 7 eingeschaltet, wenn die relative Luftfeuchtigkeit im Innengehäuse 7 auf Werte größer 60% ansteigt; die Entfeuchtungseinrichtung 25 im Innengehäuse 7 wird wieder abgeschaltet, wenn die relative Luftfeuchtigkeit im Innengehäuse 7 auf Werte kleiner 30% abfällt. In ähnlicher Art und Weise kann die zusätzliche Entfeuchtungseinrichtung 46 im Außengehäuse 10 eingeschaltet werden, wenn die relative Luftfeuchtigkeit im Außengehäuse auf Werte größer 60% ansteigt; die zusätzliche Entfeuchtungseinrichtung 46 im Außengehäuse 10 kann wieder abgeschaltet werden, wenn die relative Luftfeuchtigkeit im Außengehäuse auf Werte kleiner 30% abfällt. Die Werte 30% und 60% sind nur als Beispiele zu verstehen. Die Luftfeuchtigkeit wird dabei mittels eines oder mehrerer Luftfeuchtigkeitssensoren gemessen.

Da das Innengehäuse nur wenig Material enthält und eine geringe Wärmekapazität aufweist, besteht die Gefahr von großen Temperatur-Regelungsschwankungen. Daher wird optional der Wärmepuffer 55 eingesetzt, beispielsweise eine massive Metallplatte 55. Bei der Temperaturregelung sowie bei einem kurzzeitigen Ausfall der Temperaturregelung ist somit die Änderung der Temperatur im Innengehäuse gemäßigt/gedämpft. Dies kann die Lebensdauer der Anwendungselektronik im Innengehäuse verlängern.

Da das Innengehäuse nur wenig Material enthält und ein relativ kleines Volumen umschließt, besteht die Gefahr von großen Feuchtigkeitsschwankungen, insbesondere beim Einschalten der Entfeuchtungseinrichtung oder bei einem plötzlichen Eindringen von Luftfeuchtigkeit in das Innengehäuse (z.B. durch Luftdruckschwankungen oder Undichtigkeiten). Daher wird optional der Feuchtigkeitspuffer 58 im Innengehäuse angeordnet. Der Feuchtigkeitspuffer kann zum Beispiel ein feuchtigkeitsdurchlässiger Beutel mit hygroskopischem Material (z.B. Tonerdefüllung) sein, der in dem Innengehäuse angeordnet ist. Bei Aufheizen des Innengehäuses mittels des Heizelements kann dieses hygroskopische Material die Feuchtigkeit wieder abgeben, und das Peltierelement kann die Feuchtigkeit aus der Luft herauskondensieren. Diese Art des Feuchtepuffers ist - insbesondere im Gegensatz zu Silicagel - dauerhaft wartungsfrei. Ein solcher Feuchtigkeitspuffer kann optional auch im Außengehäuse angeordnet sein.

Optional kann das Einlaufen von Tropfwasser von oben in das Innengehäuse verhindert werden, indem das Innengehäuse an der Verbindungsstelle zwischen Haltewand 16 und Aufsatzgehäuse 22 einen geneigten Wasserablauf in Form einer Wasserablaufrinne aufweist (nicht in der Figur dargestellt). Dadurch kann das Wasser nur seitlich des Innengehäuses ablaufen und nicht von oben in den Spalt zwischen Haltewand 16 und Aufsatzgehäuse 22 einsickern. Ein Überstand des Aufsatzgehäuse 22 über die Montageplatte stellt sicher, dass das Wasser außen am Innengehäuse abläuft und nicht in das Innengehäuse hineinlaufen kann. Optional kann das Aufsatzgehäuse am oberen Rand der Haltewand drehbar gelagert sein, so dass ein Schließen des Aufsatzgehäuses durch eine Drehbewegung des Aufsatzgehäuses (schwenken) von oben nach unten möglich ist. Es liegt dann eine Art Scharnier vor, das mit dem Wasserablauf kombiniert sein kann.

Die Gehäuseanordnung und das Verfahren können insbesondere bei Mittel-, Hoch- und Höchstspannungsanlagen eingesetzt werden. Es können sich insbesondere die folgenden Eigenschaften bzw. Vorteile ergeben:
- Dezentrale Erfassung und Verarbeitung von Mess-, Regel- und Steuerungsgrößen im Feld.
- Entfall von zahlreichen störanfälligen Kupferkabeln im Feld.
- Erhöhte Zuverlässigkeit und Genauigkeit in der Signalübertragung, z.B. weitgehender Entfall der Fehlerquelle "kalibriertes Anschlusskabel" eines Spannungsteilers.
- Reduzierter Energiebedarf für die Klimatisierung und Entfeuchtung des Inneren des Innengehäuses. Minimierung der Baugröße des Innengehäuses durch Anordnung der "robusten" Elektronik-Baugruppen mit weitem zulässigen Arbeits-, Temperatur- und Feuchtebereich im Außengehäuse, dadurch ergibt sich eine Reduzierung der abzuführenden Verluste der Baugruppen im Innengehäuse.
- Trennung der Aufgaben:
   Die Aufgabe "mechanischer Schutz" und "Verschließbarkeit" (wird vom Außengehäuse erfüllt, zum Beispiel ausgestaltet als Metallbox) ist getrennt von der Aufgabe "thermische Isolierung und Minimierung des Luftaustauschs mit der Umgebung", hier erfüllt vom thermisch isolierten Innengehäuse.
- Frostsicherheit: Abfuhr des Kondenswassers durch Abflussschlauch mit sehr kleinem freiem Querschnitt und Kapillaren (und ggf. Heizdraht in den Kapillaren oder benachbart zu den Kapillaren).
- Sichere Trennung von Elektronik und Kondenswasser durch Integration des Peltierelements in die (vertikale) Frontplatte des Innengehäuses.
- Vollständiger Verzicht auf ein energieaufwändiges Heizen des Außengehäuses (ungeheiztes Außengehäuse); mit dem reduzierten Energiebedarf ist insbesondere eine Speisung aus einer "teuren" gepufferten DC-Versorgung der Anlage möglich.
- Einheitliche Lösung für Umgebungen mit sehr hohen und aber auch mit sehr niedrigen Temperaturen.
- Dauerhaft wartungsfreier Aufbau (keine rotierenden Teile).
- Einführung von Trägheit für Wärme (durch Wärmespeicher/Wärmepuffer) und für Feuchtigkeit (durch Feuchtigkeitsspeicher/Feuchtigkeitspuffer) und damit gutmütigeres Regelverhalten für beide Größen und Reduktion des Stresses für die in dem Innengehäuse befindliche elektronische Schaltung oder Schaltungen. Die Trägheit ermöglicht auch sicheren Betrieb der Elektronik bei Ausfall der Klimatisierung über Stunden/Tage.
   Durch den Wärmepuffer kann insbesondere die erforderliche Schaltfrequenz der Heizung und der Kühlung des Innengehäuses verringert werden oder die Regelungszeitkonstante kann erhöht werden, was zu einem gutmütigeren Regelverhalten führt.
- Tropfwassersichere Ausgestaltung des Innengehäuses.

Es wurde eine Gehäuseanordnung für eine elektronische Schaltung sowie ein Verfahren zur Klimatisierung einer in einer Gehäuseanordnung angeordneten elektronischen Schaltung beschrieben, die in einem weiten Klimabereich einsetzbar sind und insbesondere die kostenintensive Verlegung von Kabeln bis zu einem Kontrollraum verringern.

## Patentansprüche

1. Gehäuseanordnung (1) für eine elektronische Schaltung (4) mit einem Innengehäuse (7) und einem das Innengehäuse (7) umgebenden Außengehäuse (10), wobei das Innengehäuse (7) thermisch isolierende Gehäusewände (16, 22) und eine elektrische Entfeuchtungseinrichtung (25) aufweist,
**dadurch gekennzeichnet, dass**
- in dem Innengehäuse (7) und/oder dem Außengehäuse (10) ein Feuchtigkeitspuffer (58) angeordnet ist,
- der Feuchtigkeitspuffer (58) ein hygroskopisches Material aufweist, und
- der Feuchtigkeitspuffer (58) elektrisch beheizbar (61) ist, um von dem hygroskopischen Material gebundenes Wasser in den gasförmigen Aggregatzustand zu überführen.

2. Gehäuseanordnung nach Anspruch 1,
**dadurch gekennzeichnet, dass**
- das Innengehäuse (7) ein Volumen umschließt, das maximal 50 % des Volumens beträgt, welches das Außengehäuse (10) umschließt.

3. Gehäuseanordnung nach Anspruch 1 oder 2,
**dadurch gekennzeichnet, dass**
- die Entfeuchtungseinrichtung (25) ein Peltierelement (28) und eine Kondensatabführung (31) aufweist.

4. Gehäuseanordnung nach Anspruch 3,
**dadurch gekennzeichnet, dass**
- das Peltierelement (28) in der Lage ist, eine Temperaturdifferenz von 40 Kelvin zu erzeugen.

5. Gehäuseanordnung nach Anspruch 3 oder 4,
**dadurch gekennzeichnet, dass**
- die Kondensatabführung (31) Kapillaren (34) aufweist.

6. Gehäuseanordnung nach Anspruch 5,
**dadurch gekennzeichnet, dass**
- die Kapillaren (34) beheizbar sind.

7. Gehäuseanordnung nach Anspruch 5 oder 6,
**dadurch gekennzeichnet, dass**
- den Kapillaren (34) eine elektrische Beheizungsvorrichtung (37) zugeordnet ist, insbesondere ein elektrischer Heizdraht (37) .

8. Gehäuseanordnung nach einem der vorhergehenden Ansprüche,
**dadurch gekennzeichnet, dass**
- eine Stromversorgungseinrichtung (43) für die Entfeuchtungseinrichtung (25) in einem Zwischenraum zwischen dem Innengehäuse (7) und dem Außengehäuse (10) angeordnet ist.

9. Gehäuseanordnung nach einem der vorhergehenden Ansprüche,
**dadurch gekennzeichnet, dass**
- in dem Zwischenraum zwischen dem Innengehäuse (7) und dem Außengehäuse (10) eine zusätzliche Entfeuchtungseinrichtung (46) angeordnet ist, die insbesondere ein zusätzliches Peltierelement (49) aufweist.

10. Gehäuseanordnung nach einem der vorhergehenden Ansprüche,
**dadurch gekennzeichnet, dass**
- in dem Innengehäuse (7) ein elektrisches Heizelement (52) angeordnet ist.

11. Gehäuseanordnung nach einem der vorhergehenden Ansprüche,
**dadurch gekennzeichnet, dass**
- in dem Innengehäuse (7) ein Wärmepuffer (55) angeordnet ist.

12. Gehäuseanordnung nach Anspruch 11,
**dadurch gekennzeichnet, dass**
- der Wärmepuffer (55) ein wärmepufferndes Metallteil aufweist.

13. Gehäuseanordnung nach einem der vorhergehenden Ansprüche,
**dadurch gekennzeichnet, dass**
- eine Wand des Innengehäuses als eine Haltewand (16) für die elektronische Schaltung (4) ausgestaltet ist, insbesondere als eine thermisch isolierende Montageplatte (16).

14. Gehäuseanordnung nach einem der vorhergehenden Ansprüche,
**dadurch gekennzeichnet, dass**
- das Außengehäuse (10) ein Metallgehäuse ist.

15. Gehäuseanordnung nach einem der vorhergehenden Ansprüche,
**dadurch gekennzeichnet, dass**
- die Gehäuseanordnung (1) frei von rotierenden Teilen ist, insbesondere frei von elektrischen Kompressoren.

16. Verfahren zum Klimatisieren einer in einer Gehäuseanordnung (1) angeordneten elektronischen Schaltung (4), wobei die Gehäuseanordnung (1) ein Innengehäuse (7) und ein das Innengehäuse (7) umgebendes Außengehäuse (10) aufweist und das Innengehäuse (7) thermisch isolierende Gehäusewände (16, 22) und eine elektrische Entfeuchtungseinrichtung (25) aufweist, in dem Innengehäuse (7) und/oder dem Außengehäuse (10) ein Feuchtigkeitspuffer (58) angeordnet ist, der Feuchtigkeitspuffer (58) ein hygroskopisches Material aufweist, und der Feuchtigkeitspuffer (58) elektrisch beheizbar (61) ist, wobei bei dem Verfahren
- bei Überschreiten eines Schwellenwertes der relativen Luftfeuchtigkeit in dem Innengehäuse (7) die Entfeuchtungseinrichtung (25) eingeschaltet wird und dadurch die relative Luftfeuchtigkeit in dem Innengehäuse (7) reduziert wird, und
- bei Beheizung des Feuchtigkeitspuffers (58) von dem hygroskopischen Material gebundenes Wasser in den gasförmigen Aggregatzustand überführt wird.

17. Verfahren nach Anspruch 16,
**dadurch gekennzeichnet, dass**
- die Entfeuchtungseinrichtung (25) ein Peltierelement (28) aufweist, wobei das Peltierelement (28) abwechselnd als Kühlelement und als Heizelement für den Innenraum des Innengehäuses (7) betrieben wird.

## Claims

1. Housing assembly (1) for an electronic circuit (4), having an interior housing (7) and an exterior housing (10) surrounding the interior housing (7), wherein the interior housing (7) has thermally insulating housing walls (16, 22) and an electrical dehumidifying unit (25),
**characterized in that**
- a moisture buffer (58) is arranged in the interior housing (7) and/or the exterior housing (10),
- the moisture buffer (58) comprises a hygroscopic material, and
- the moisture buffer (58) is electrically heatable (61), in order to transform water bound by the hygroscopic material into the gaseous state of aggregation.

2. Housing assembly according to Claim 1,
**characterized in that**
- the interior housing (7) encloses a volume which is a maximum of 50% of the volume that the exterior housing (10) encloses.

3. Housing assembly according to Claim 1 or 2,
**characterized in that**
- the dehumidifying unit (25) has a Peltier element (28) and a condensate discharge (31).

4. Housing assembly according to Claim 3,
**characterized in that**
- the Peltier element (28) is capable of generating a temperature difference of 40 kelvins.

5. Housing assembly according to Claim 3 or 4,
**characterized in that**
- the condensate discharge (31) has capillaries (34).

6. Housing assembly according to Claim 5,
**characterized in that**
- the capillaries (34) are heatable.

7. Housing assembly according to Claim 5 or 6,
**characterized in that**
- the capillaries (34) are assigned an electrical heating device (37), in particular an electrical heating wire (37).

8. Housing assembly according to one of the preceding claims,
**characterized in that**
- a power supply unit (43) for the dehumidifying unit (25) is arranged in an intermediate space between the interior housing (7) and the exterior housing (10).

9. Housing assembly according to one of the preceding claims,
**characterized in that**
- an additional dehumidifying unit (46), which in particular has an additional Peltier element (49), is arranged in the intermediate space between the interior housing (7) and the exterior housing (10).

10. Housing assembly according to one of the preceding claims,
**characterized in that**
- an electrical heating element (52) is arranged in the interior housing (7).

11. Housing assembly according to one of the preceding claims,
**characterized in that**
- a heat buffer (55) is arranged in the interior housing (7).

12. Housing assembly according to Claim 11,
**characterized in that**
- the heat buffer (55) has a heat-buffering metal part.

13. Housing assembly according to one of the preceding claims,
**characterized in that**
- a wall of the interior housing is designed as a holding wall (16) for the electronic circuit (4), in particular as a thermally insulating mounting plate (16).

14. Housing assembly according to one of the preceding claims,
**characterized in that**
- the exterior housing (10) is a metal housing.

15. Housing assembly according to one of the preceding claims,
**characterized in that**
- the housing assembly (1) is free from rotating parts, in particular free from electrical compressors.

16. Method for controlling the climatic conditions of an electronic circuit (4) arranged in a housing assembly (1), wherein the housing assembly (1) has an interior housing (7) and an exterior housing (10) surrounding the interior housing (7) and the interior housing (7) has thermally insulating housing walls (16, 22) and an electrical dehumidifying unit (25), a moisture buffer (58) is arranged in the interior housing (7) and/or the exterior housing (10), the moisture buffer (58) comprises a hygroscopic material, and the moisture buffer (58) is electrically heatable (61), wherein in the method
- when a threshold value of the relative atmospheric humidity in the interior housing (7) is exceeded, the dehumidifying unit (25) is switched on and as a result the relative atmospheric humidity in the interior housing (7) is reduced, and
when the moisture buffer (58) is heated, water bound by the hygroscopic material is transformed into the gaseous state of aggregation.

17. Method according to Claim 16,
**characterized in that**
- the dehumidifying unit (25) has a Peltier element (28), wherein the Peltier element (28) is operated alternately as a cooling element and as a heating element for the interior space of the interior housing (7).

## Revendications

1. Agencement (1) de boîtiers pour un circuit (4) électronique comprenant un boîtier (7) intérieur et un boîtier (10) extérieur entourant le boîtier (7) intérieur, dans lequel le boîtier (7) intérieur a des parois (16, 22) isolantes thermiquement et un dispositif (25) électrique de déshumidification,
**caractérisé en ce que**
- un tampon (58) à l'humidité est disposé dans le boîtier (7) intérieur et/ou dans le boîtier (10) extérieur,
- le tampon (58) à l'humidité a une matière hygroscopique, et
- le tampon (58) à l'humidité peut être chauffé (61) électriquement pour faire passer de l'eau fixée par la matière hygroscopique à l'état gazeux de la matière.

2. Agencement de boîtiers suivant la revendication 1,
**caractérisé en ce que**
- le boîtier (7) intérieur enferme un volume, qui représente au maximum 50 % du volume qu'enferme le boîtier (10) extérieur.

3. Agencement de boîtiers suivant la revendication 1 ou 2,
**caractérisé en ce que**
- le dispositif (25) de déshumidification a un élément (28) Peltier et une évacuation (31) de produit condensé.

4. Agencement de boîtiers suivant la revendication 3,
**caractérisé en ce que**
- l'élément (28) Peltier est en mesure de produire une différence de température de 40 kelvin.

5. Agencement de boîtiers suivant la revendication 3 ou 4,
**caractérisé en ce que**
- l'évacuation (31) de produit condensé comporte des capillaires (34) .

6. Agencement de boîtiers suivant la revendication 5,
**caractérisé en ce que**
- les capillaires (34) peuvent être chauffés.

7. Agencement de boîtiers suivant la revendication 5 ou 6,
**caractérisé en ce qu'**
- aux capillaires (34) est associé un dispositif (37) électrique de chauffage, notamment un fil (37) électrique de chauffage.

8. Agencement de boîtiers suivant l'une des revendications précédentes,
**caractérisé en ce que**
- un dispositif (43) d'alimentation en courant du dispositif (25) de déshumidification est disposé dans un espace intermédiaire entre le boîtier (7) intérieur et le boîtier (10) extérieur.

9. Agencement de boîtiers suivant l'une des revendications précédentes,
**caractérisé en ce que**
- dans l'espace intermédiaire entre le boîtier (7) intérieur et le boîtier (10) extérieur est disposé un dispositif (46) supplémentaire de déshumidification, qui a, en particulier, un élément (49) Peltier supplémentaire.

10. Agencement de boîtiers suivant l'une des revendications précédentes,
**caractérisé en ce qu'**
- un élément (52) électrique de chauffage est disposé dans le boîtier (7) intérieur.

11. Agencement de boîtiers suivant l'une des revendications précédentes,
**caractérisé en ce qu'**
- un tampon (55) à chaleur est disposé dans l'espace (7) intérieur.

12. Agencement de boîtiers suivant la revendication 11,
**caractérisé en ce que**
- le tampon (55) à chaleur a une partie métallique faisant tampon à chaleur.

13. Agencement de boîtiers suivant l'une des revendications précédentes,
**caractérisé en ce que**
- une paroi du boîtier intérieur est conformée en paroi (16) de retenue du circuit (4) électronique, notamment sous la forme d'une plaque (16) de montage isolante thermiquement.

14. Agencement de boîtiers suivant l'une des revendications précédentes,
**caractérisé en ce que**
- le boîtier (10) extérieur est un boîtier métallique.

15. Agencement de boîtiers suivant l'une des revendications précédentes,
**caractérisé en ce que**
- l'agencement (1) de boîtiers est sans partie tournante, en étant notamment sans compresseur électrique.

16. Procédé de climatisation d'un circuit (4) électronique disposé dans un agencement (1) de boîtiers, dans lequel l'agencement (1) de boîtiers a un boîtier (7) intérieur et un boîtier (10) extérieur entourant le boîtier (7) intérieur, dans lequel le boîtier (7) intérieur a des parois (16, 22) isolantes thermiquement et un dispositif (25) électrique de déshumidification, un tampon (58) à l'humidité est disposé dans le boîtier (7) intérieur et/ou dans le boîtier (10) extérieur, le tampon (58) à l'humidité a une matière hygroscopique, et le tampon (58) à l'humidité peut être chauffé (61) électriquement, dans lequel, dans le procédé
- si une valeur de seuil de l'humidité relative de l'air dans le boîtier (7) intérieur est dépassée, on met le dispositif (25) de déshumidification en circuit et on réduit ainsi l'humidité relative de l'air dans le boîtier (7) intérieur, et
- en chauffant le tampon (58) à l'humidité, on fait passer de l'eau fixée à la matière hygroscopique à l'état gazeux de la matière.

17. Procédé suivant la revendication 16,
**caractérisé en ce que**
- le dispositif (25) de déshumidification a un élément (28) Peltier, dans lequel on fait fonctionner l'élément (28) Peltier en alternance comme élément de refroidissement et comme élément de chauffage de l'espace intérieur du boîtier (7) intérieur.
